# EUROPEAN PATENT APPLICATION

(11) **EP 1 054 507 A2**
(43) Date of publication of application: **22.11.2000**
(21) Application number: 00302467.6
(22) Date of filing: 27.03.2000
(51) Int. Cl.: H03F 3/60

(54) **Mobile station employing single ended use of a differential power amplifier for reduced output power**

(30) Priority: 19.05.1999 US 314818
(71) Applicant: NOKIA MOBILE PHONES LTD., 02150 Espoo (FI)
(72) Inventor: Limatainen, Jukka, 90520 Oulu (FI)
(74) Representative: Read, Matthew Charles

(57) **Abstract**

An RF power amplifier circuit includes a first amplifier and a second amplifier each having an input that is driven from a signal source with a same signal in a phase relationship other than zero, preferably either antiphase or quadrature. The first and second amplifiers each further having an output. A three terminal output network has a first input node coupled to the output of the first amplifier, a second input coupled to the output of the second amplifier, and an output node for coupling to a load, typically an antenna. The output network operates in a first, balanced mode of operation for combining the output signals in-phase from both of the first and second amplifiers and for outputting a signal to the output node. The output network further operates, in one embodiment, in a second, unbalanced mode of operation for introducing a predetermined amount of loss into the output signal from only one of the amplifiers before outputting the signal to the output node. In one embodiment the output network is based on a Wilkinson coupler, while in another embodiment the output network is based on a stripline balun (balanced/unbalanced transformer) and the Wilkinson coupler.

## Description

### FIELD OF THE INVENTION:

This invention relates generally to radio telephones and, in particular, to radio telephones or mobile stations such as those capable of providing a plurality of transmitter output power levels. This invention further relates in general to the field of telecommunications and radio telephones and, more particularly, to the efficient use of RF power amplifiers having differing output power requirements.

### BACKGROUND OF THE INVENTION:

An example of a RF power amplifier having differing output power requirements can be found in a mobile terminal or mobile phone that efficiently supports the use of both voice communications and high rate data transmission. Such requirements will be imposed on mobile phones designed for, by example, the so-called third generation wideband CDMA (WCDMA) networks. In this type of system the maximum output power for a voice-only mobile terminal has been proposed to be 21 dBm. However, for data communications one defined power class is 24 dBm, and the use of several code channels for increased data transmission rates further effectively increases the required output power from the mobile terminal.

It can thus be appreciated that a need exists to adapt the transmitter RF power amplifier of the mobile terminal for the different output power requirements, while maintaining a high conversion efficiency from the terminal's DC supply to the required RF carrier power.

A problem has arisen, however, in the design of an RF power amplifier that provides a wide range of output power, or a number of different output power classes, in the frequency bands of interest, and which at the same time maintains good RF conversion efficiency and a linear operation. In many applications, especially in portable equipment, the supply voltage for the RF power amplifier is essentially fixed. This results in a situation where the operation at optimum efficiency is obtained only at a single output power level, with a single device, for a given linearity requirement. The maximum output power class for a given application thus determines the design of the output device (i.e., the RF transmitter output power stage). A lower output power inevitably yields a lower efficiency of operation.

Until the present time, those requiring an RF transmitter output power stage that was capable of efficient operation over a range of output power levels, with the high degree of linearity required for phase modulated operation, were required to settle instead for an RF power amplifier with a reduced efficiency in the typically lower power voice mode. Alternatively, one could provide two RF power amplifiers, with one being optimized for voice-only mode and the other for the data mode. However, this approach adds cost and complexity, and furthermore requires additional volume to accommodate the second RF output power stage (and any RF switching circuitry that may be required).

There are several high efficiency amplifier classes presented in the literature. Unfortunately, many of these highly efficient amplifier classes are only suitable for non-linear operation while some, like the class D switching amplifier, are actually capable of producing a linear output power with a varying signal envelope. However, the class D amplifier is not, at the present time, developed for operation at the frequencies that are typically required for mobile telecommunications.

A technique known as "envelope elimination and restoration" could possibly be used to provide an efficient non-linear RF amplifier, but this approach is at present severely limited in its ability to handle wide bandwidth signals.

The use of RF switches to select one of several power amplifiers with differing output power capabilities is one solution that has been suggested to decrease current consumption at lower power levels. If successfully implemented this method could be expected to produce good results. However, this method requires an extensive RF switching network which introduces losses in the signal path(s) and which decreases efficiency at high power levels. For continuous wave applications the switching furthermore introduces a problem of phase discontinuity. These problems are difficult to solve, and complicate the approach considerably.

### OBJECTS AND ADVANTAGES OF THE INVENTION:

It is thus a first object and advantage of this invention to provide an improved RF transmitter power stage for a mobile terminal overcomes the foregoing and other problems.

It is a further object and advantage of this invention to provide an improved RF transmitter power stage for a battery powered mobile terminal that is capable of providing a plurality of output power levels, while maintaining good linearity and power conversion efficiency.

It is a another object and advantage of this invention to provide an improved RF transmitter power stage for a mobile terminal that is capable of providing the power and linearity required for high data rate applications, while maintaining acceptable power conversion efficiencies when operating in a voice-only mode.

### SUMMARY OF THE INVENTION

The foregoing and other problems are overcome and the objects of the invention are realized by methods and apparatus in accordance with embodiments of this invention.

An RF power amplifier is provided with a differential input and output. For a high output power application the RF power amplifier is used as a differential amplifier, and when a lower output power is required the output is applied in a single ended fashion. A difference between the two modes is 6 dB. For the low power mode of operation the unused transistor/transistors in the unused differential branch are preferably shut down to avoid unnecessary power consumption, thereby reducing quiescent current consumption. In this manner an efficient operation mode that is 6 dB below the maximum output power level can be realized.

The inventive methods and apparatus enable an efficient use of a single power amplifier in two different power classes. As an example, the difference in output power requirements for a WCDMA mobile terminal is approximately 6 dB between the voice-only and the multicode data transmission cases. This 6 dB difference is well-accommodated by the properties of the novel RF power amplifier stage arrangement described by this invention.

The teachings of this invention may be used to provide two operating modes (voice/data) for a single terminal. Another important benefit can be obtained by using a single, common design RF power amplifier stage (device) for dedicated voice-only terminals, as well as for voice/data terminals.

If a stepwise transition of power amplifier gain can be tolerated/compensated by the system power controller, the teachings of this invention can be applied for improving the overall efficiency of the RF power amplifier over a wide dynamic range, and is thus an application suitable for general use in all systems where a linear or substantially linear operation over a given power control range is required.

For the balanced operation case the outputs of the differential amplifier are added in-phase. Therefore the output power of each differential branch is 3 dB less than the added power (assuming a loss-less combining network). In that an amplifier designed for a lower output power has a lower quiescent current, a saving in current at low output levels is achieved after turning off one half of the balanced amplifier, as compared to an amplifier designed to operate single ended with up to 3 dB more output power.

In accordance with the teachings of this invention an RF power amplifier circuit includes a first amplifier and a second amplifier. Each of the two (identical) amplifiers has an input that is driven from a signal source with a same signal in a phase relationship other than zero, preferably either antiphase or quadrature. The first and second amplifiers each further having an output. A three terminal output network has a first input node coupled to the output of the first amplifier, a second input coupled to the output of the second amplifier, and an output node for coupling to a load, typically an antenna.

In one embodiment the output network operates in a first, balanced mode of operation for combining the output signals in-phase from both of the first and second amplifiers and for outputting a signal to the output node. The output network further operates in a second, unbalanced mode of operation for introducing a predetermined amount of loss into the output signal from only one of the amplifiers, before outputting the signal to the output node.

In another embodiment the output network avoids introducing loss into the output signal, and instead a switch is opened when operating in the balanced mode of operation and is closed when operating in the unbalanced mode of operation. The switch being closed changes the output impedance of the active amplifier by transforming the impedance of a stripline (Z2) to appear substantially as an open circuit to the signal output from the active amplifier.

In one embodiment the output network is based on a Wilkinson coupler, while in another embodiment the output network is based on a stripline balun (balanced/unbalanced transformer) and the Wilkinson coupler.

### BRIEF DESCRIPTION OF THE DRAWINGS

The above set forth and other features of the invention are made more apparent in the ensuing Detailed Description of the Invention when read in conjunction with the attached Drawings, wherein:
Fig. 1 is a block diagram of a mobile station that is constructed and operated in accordance with this invention;
Fig. 2 is an elevational view of the mobile station shown in Fig. 1, and which further illustrates a cellular communication system to which the mobile station is bidirectionally coupled through wireless RF links;
Figs. 3, 4 and 5 each depict an embodiment of a different output network for combining the outputs of two identical antiphase excited amplifiers in accordance with the teachings of this invention; and
Fig. 6 is a more detailed block diagram of a portion of the mobile station of Fig. 1, and illustrates the RF transmitter power stage in accordance with the teachings of this invention.

### DETAILED DESCRIPTION OF THE INVENTION

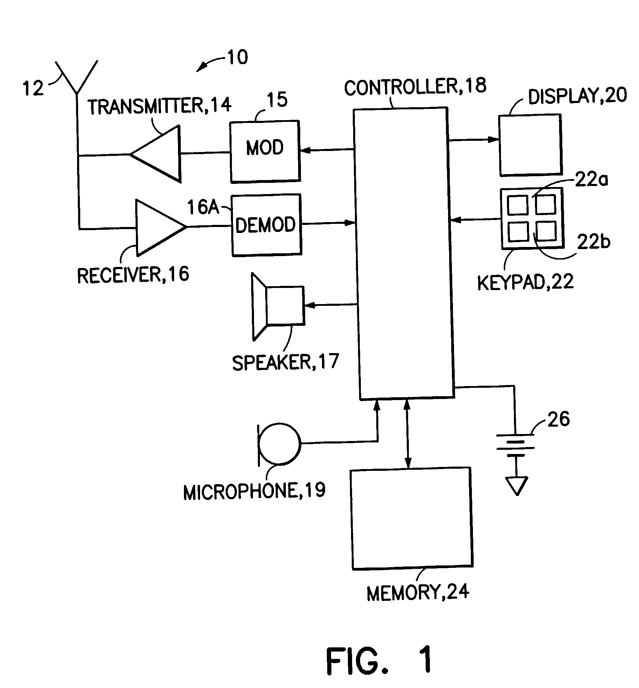

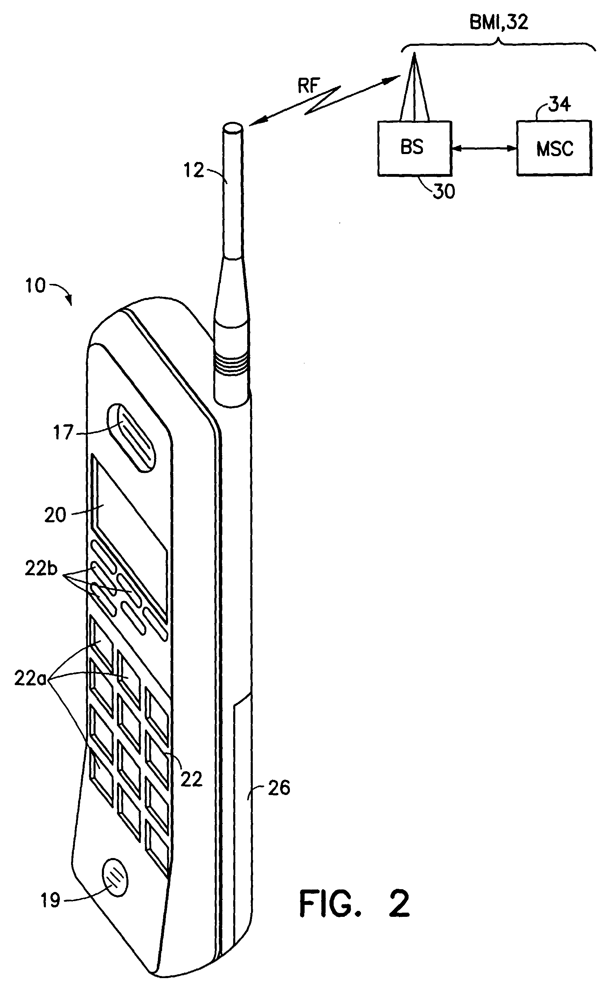

Reference is made to Figs. 1 and 2 for illustrating a wireless mobile terminal or mobile station 10, such as but not limited to a cellular radiotelephone or a personal communicator, that is suitable for practicing this invention. The mobile station 10 includes an antenna 12 for transmitting signals to and for receiving signals from a base site or base station 30. The base station 30 can be part of a telecommunications network comprising a Base Station/Mobile Switching Center/Interworking function (BMI) 32 that includes a mobile switching center (MSC) 34. The MSC 34 typically provides a connection to landline trunks when the mobile station 10 is involved in a call.

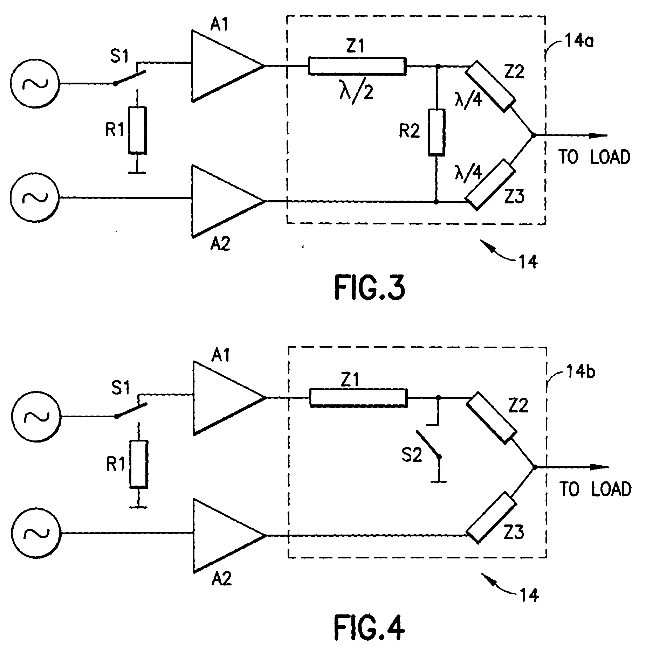

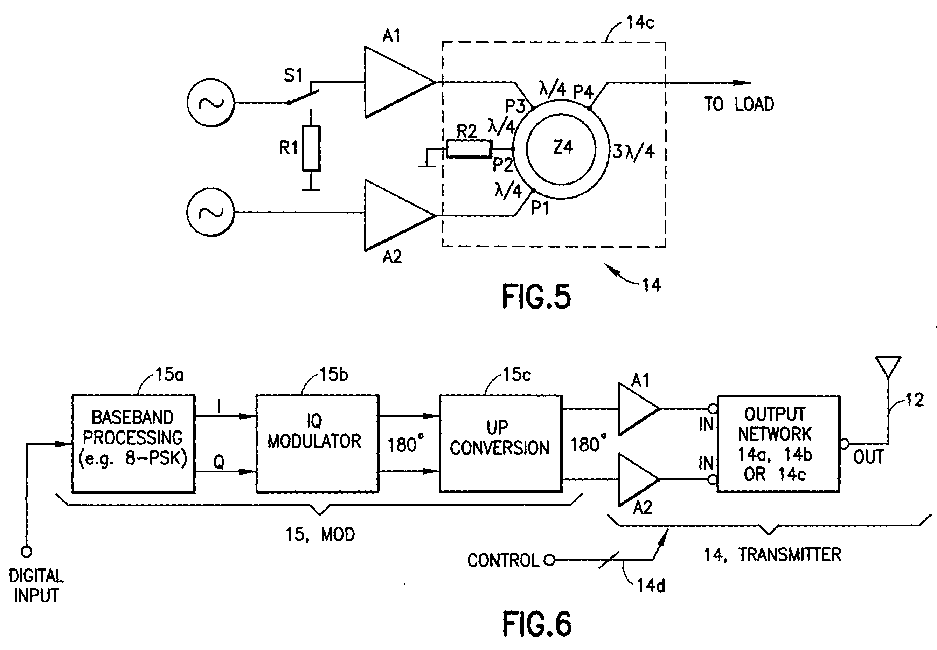

The mobile station 10 includes a modulator (MOD) 15 (shown in further detail in Fig. 6), a transmitter 14 (described in further detail below with regard to Figs. 3-6), a receiver 16, a demodulator (DEMOD) 16A, and a controller 18 that provides signals to and receives signals from the transmitter 14 and receiver 16, respectively. These signals include signalling information in accordance with the air interface standard of the applicable wireless telecommunications system, and also user speech and/or data.

It is understood that the controller 18 also includes the circuitry required for implementing the audio and logic functions of the mobile station 10. By example, the controller 18 may be comprised of a digital signal processor device, a microprocessor device, and various analog to digital converters, digital to analog converters, and other support circuits. The control and signal processing functions of the mobile station are allocated between these devices according to their respective capabilities.

A user interface includes a conventional earphone or speaker 17, a conventional microphone 19, a display 20, and a user input device, typically a keypad 22, all of which are coupled to the controller 18. The keypad 22 includes the conventional numeric (0-9) and related keys (#,*) 22a, and other keys 22b used for operating the mobile station 10. These other keys 22b may include, by example, a SEND key, various menu scrolling and soft keys, and a PWR key. The mobile station 10 also typically includes a battery 26 for powering the various circuits that are required to operate the mobile station.

The mobile station 10 also includes various memories, shown collectively as the memory 24, wherein are stored a plurality of constants and variables that are used by the controller 18 during the operation of the mobile station. For example, the memory 24 stores the values of various system parameters and the number assignment module (NAM). An operating program for controlling the operation of controller 18 is also stored in the memory 24 (typically in a ROM device). The memory 24 may also store data that is received from or transmitted to the BMI 32.

It should be understood that the mobile station 10 can be a vehicle mounted or a handheld device. It should further be appreciated that the mobile station 10 can be capable of operating with one or more air interface standards, modulation types, and access types. The WCDMA application mentioned previously is only one suitable embodiment of the teachings of this invention, since TDMA, by example, mobile terminals may also benefit from the teachings of this invention. It should thus be clear that the teachings of this invention are not to be construed to be limited to any one particular type of mobile station or air interface type.

Figs. 3, 4 and 5 each depict an embodiment of a different output network 14a, 14b and 14c, respectively, for combining the outputs of two identical parallel, antiphase excited amplifiers A1 and A2 in accordance with the teachings of this invention. The amplifiers A1 and A2, as well as individual ones of the output networks 14a, 14b and 14c, form a part of the RF transmitter 14 shown in Fig. 1. By antiphase excited it is meant that one amplifier is driven with a signal that is 180° out of phase with the signal that drives the other amplifier. However, in other embodiments the two amplifier inputs could be in a quadrature (90°) relationship, and the output network is then adjusted accordingly so that the combined signals are in-phase at the output node for application to the desired load (typically an antenna).

Figs. 3, 4 and 5 each illustrate a series switch S1 for disconnecting an RF signal source from the input of the power amplifier A1. The resistor R1 acts as a dummy load for the RF signal source, as the mismatch due to the disconnection may affect the operation of the signal source. As such, the dummy load represented by R1 may not be required in all applications of the teachings of this invention, and is shown in Figs. 3-5 for completeness.

Furthermore, any possible phase and/or amplitude imbalance resulting from having the input switch located only in one of the balanced branches could be entirely eliminated by adding an identical switching network to the other branch (i.e., at the input to A2).

An important consideration when implementing a power amplifier that effectively utilizes the teachings of this invention is the design of the output network 14a, 14b or 14c. The output network should combine the two output signals for providing balanced operation, and yet should allow operation in a lower power, single ended mode.

In Fig. 3 a half wavelength stripline Z1 (Zo = 50 Ω) shifts the outputs of A1 and A2 in-phase. A length of the one half wavelength stripline Z1 (on a FR4 substrate) at the frequencies of interest (e.g., about 2GHz) is about 4 cm. Two quarter wavelength striplines Z2 (Zo = 70.7 Ω) and Z3 (Zo = 70.7 Ω) and resistor R2 (100 Ω) form a Wilkinson coupler that is used to combine the outputs of A1 and A2. During balanced operation both A1 and A2 see a 50 Ω load, and R2 does not dissipate power (provided the outputs of A1 and A2 are matched).

Turning A1 off, with full input drive to the amplifier, drops the output power by 6 dB. That is, a 3 dB loss results from removing the input signal to A1 (by opening S1), and another 3 dB loss occurs in R2. This ensures that the output of A1 remains isolated from the output signal from A2.

The 3 dB loss due to the Wilkinson coupler reduces the overall efficiency during the single ended operation. However, when considering a situation where the amplifier is used in the balanced mode, while the power is backed off, a point can be identified where the efficiency reduction due to Wilkinson coupler losses is smaller than the efficiency degradation due to the quiescent currents in A1 and A2. At this point A1 can then be switched off to improve the total efficiency at lower output levels. The gain drop of 6 dB is then compensated for by increasing the input drive level accordingly.

It should be noted that the load impedance seen by the output stage of A2 remains constant, and thus the output network 14a does not introduce a significant phase shift to the signal output from A2. As the amplifier is expected to operate under linear conditions, the phase shift due to amplitude modulation/phase modulation conversion upon increasing the input drive level is rather small, which is beneficial for those applications requiring phase continuity.

A second output network topology is shown in Fig. 4. Here the resistor of the Wilkinson coupler (R2 of Fig. 3) has been removed, as it is not needed when all of the ports are matched (which is the case during balanced operation.) An on/off RF switch S2 is located between ground and the common node of Z1 (Zo = 70.7 Ω) and Z2 (Zo = 70.7Ω). The RF switch S2 could be a PIN diode or a GaAs switch. For balanced operation the switch S2 is held open (not conducting) and the operation of the output network 14b is similar to the operation of the output network 14a of Fig. 3. However, when A1 is turned off the switch S2 is closed, thereby coupling the common node of Z1 and Z2 to AC ground. The opposite, load end of Z2 then shows a high impedance (effectively an open circuit to the RF signal output from A2), and thus does not disturb the signal output from A2 from passing to the load. As the load impedance remains at 50 Ω the quarter wavelength strip Z3 effectively transforms the impedance seen by the output stage of A2 to 100 Ω. If the output of A2 is then backed off 3 dB from the maximum (6 dB from maximum in the balanced mode), and if the primary load seen at the primary output of the active device of A2 doubles as well, for class B operation the efficiency of A2 remains constant. It is noted that pure class B operation is rather theoretical for practical devices, and the output matching network modifies the primary load change seen by the output device, making it difficult to estimate the actual circuit operation.

It is further noted that the load impedance change that occurs when S2 is closed effectively changes the gain of the amplifier. In the case of a power amplifier, the gain is most likely increased (the actual gain and efficiency of a power amplifier is typically a complex relationship between load impedance and bias conditions). Further in this regard, it is pointed out that the load impedance change will typically change the signal phase and gain, as well as the input impedance of the amplifier, which may limit the range of applications for the circuit shown in Fig. 4. With practical non-class-B-amplifiers an option exists of adjusting the amplifier output stage bias current according to the operational mode, which could be used to optimize the efficiency for each of the two load impedance cases.

Care should be taken to prevent intermodulation in the RF switch S2, and to compensate for the series inductance of the switch device (e.g., a PIN diode or a GaAs switch, as was stated above).

Fig. 5 shows an embodiment of an output network 14c that provides the same functionality as the output network 14a depicted in Fig. 3, while eliminating the λ/4 stripline Z1. As such, and as will be discussed in greater detail below, in some applications the topology shown in Fig. 5 may be a preferred embodiment because of its simplicity.

In Fig. 5 a power combiner Z4 (Zo = 70.7 Ω) is formed as a combination of a stripline balun (balanced/unbalanced transformer) and the Wilkinson coupler, and can be referred to as a "rat-race" hybrid. The power combiner Z4 can be embodied as a circular shaped stripline having four ports P1, P2, P3 and P4 connected at quarter wavelength spacing, except for P1 and P4 which are spaced apart at 3λ/4. An exemplary diameter of the stripline (on FR4) for frequencies of interest (e.g., about 2 GHz) is about 3.8 cm (circumference is 1.5 times λ.) The power combiner Z4 has the advantage of obtaining better isolation between the input ports P1, P3 than the Wilkinson coupler embodiment of Fig. 3.

The embodiments of Figs. 3, 4 and 5 apply to the case of the amplifiers A1 and A2 being driven in antiphase. However, and as was mentioned above, the input signal to the amplifiers A1 and A2 could be driven in quadrature phase as well, in which case the output network topology is changed accordingly. 90 degree hybrids, for example, are devices that can be used to split and combine signals in quadrature phase.

For any of the disclosed embodiments, and for single ended operation of the power amplifier (A2), either the supply voltage and/or bias current/voltage of the unused device(s) of the unused differential branch (A1) are preferably shut down. The exact implementation depends on the characteristics of the active devices used. For example, devices such as depletion-type FETs require that an applied bias voltage be held during shut down, whereas GaAs Heterojunction Bipolar Transistors (HBTs) exhibit a negligible leakage current when the bias current into the base electrode is eliminated. If a shut down mode using bias current/voltage is not sufficient, then a controllable supply voltage switch can be used to disconnect certain of the devices from the power rail.

To avoid self biasing of the devices it is important to prevent excessive RF power from entering the gate/base of any devices that are to be shut down. This can be accomplished by applying series and/or shunt RF switches at the base/gate of the devices to be shut down. It may not be necessary to apply the switches on all the devices, as it may be sufficient to eliminate the propagation of the RF drive at only one stage of the power amplifier.

As described above it can be appreciated that this invention teaches the use of two amplifiers in parallel having their respective output nodes connected to corresponding input nodes of a three terminal output network. An output node of the output network is for coupling to a load, typically an antenna. When used in a balanced mode of operation the two amplifiers are driven from different phases of the same signal (typically in antiphase) in a differential mode of operation, and each amplifier provides one half of the total desired output power (assuming a lossless output network). The outputs of the two amplifiers are combined in the output network and provided to the load. If it is desired to operate at a lower power level (such as when operating in a voice-only mode), then the input to one of the amplifiers is removed. This reduces the output power by 3 dB which, in combination with a 3 dB loss in the output network, provides a 6 dB reduction in the power of the signal provided to the load. The reduction by 6 dB in the output power is beneficial when operating in the WCDMA system, as well as in other types of systems wherein it is desired to transmit at different power levels without compromising linearity and power conversion (primary power to RF power) efficiency. In the single ended mode the unused amplifier can be switched into a low power mode of operation, thereby reducing power consumption even further. A total range over which the transmitter power circuit comprised of A1, A2 and the output network 14a, 14b or 14c can operate may be from 27 dBm to -43 dBm, assuming a third generation (3G) WCDMA system operating at about 2 GHz.

Reference in this regard can be had to Fig. 6, which illustrates one suitable embodiment of a transmit chain of the mobile terminal 10 of Fig. 1, and that includes the transmission circuitry in accordance with this invention. The modulator 15 is shown to comprise a baseband processor 15a which outputs in-phase (I) and quadrature (Q) signal components in accordance with, by example, 8-PSK modulation; an IQ modulator 15b, which outputs differential IF-signals (comprising the combined I and Q signal components) in an antiphase (180° phase shift) relationship; and an up converter 15c for up converting the IF frequency signals to the transmission frequency band (e.g., about 2 GHz). The outputs of the up converter 15c, still in the antiphase relationship, are applied to the inputs of A1 and A2, whose outputs are applied to the two input ports of the output network 14a, 14b or 14c, as described above with regard to Figs. 3-5. A digital control bus 14d, typically sourced by or at least controlled by the controller 18, is used to operate the switch S1, the switch S2 of the embodiment of Fig. 4, as well as any required power reduction circuitry (such a switch or switches which may be used to decouple A1 from the power supply when operating in the lower power, unbalanced mode of operation). Not shown are one or more gain controlled amplifiers that precede A1 and A2, and through which the controller 18 is enabled to set the output power level of the transmitter 14.

Although 8-PSK was mentioned above as a suitable modulation scheme, the teachings of this invention are certainly not limited to only this one modulation technique. By example, in a wideband CDMA (WCDMA) embodiment of this invention the uplink modulation is HPSK.

It should be further appreciated that the teachings of this invention enable the amplifiers A1 and A2, as well as the output network 14a, 14b or 14C, to be constructed as an RF power module on a common substrate in an integrated fashion.

With regard to preferred embodiments, it is noted that the choice of embodiment is application dependent. The circuit topology of Fig. 5 may be preferred due to its simplicity by avoiding the use of a high power RF switch, and its phase continuity and predictable gain characteristics. However, the circuit of Fig. 4 provides the best overall efficiency, as the losses in R2 of Fig. 5 are avoided, and furthermore the output matching is adapted according to full power/reduced power requirements. On the other hand this change of the load impedance changes the gain and the input impedance of the amplifier. Whether this is detrimental or not is very much dependent on the application and the overall RF system architecture. For example, one exemplary application environment is in certain TDMA systems in which the power level remains constant during a transmission burst (i.e., no phase discontinuity during a burst as the power amplifier would change mode between bursts as required to adapt to the output power requirement.) Also, in this application the output level is typically controlled with closed loop feedback, and the control loop could accommodate any gain changes in the power amplifier. Thus, if the cost of the switch S2 is not objectionable, or the phase discontinuity during transitioning, and the gain and input impedance changes can be managed, the circuit of Fig. 4 may be the preferred embodiment due to improved efficiency over the Fig. 5 embodiment.

Thus, although described above in the context of several exemplary embodiments, it should be realized that a number of modifications to these teachings may occur to one skilled in the art. Thus, while the invention has been particularly shown and described with respect to preferred embodiments thereof, it will be understood by those skilled in the art that changes in form and details may be made therein without departing from the scope and spirit of the invention.

## Claims

1. An RF power amplifier circuit, comprising:
a first amplifier and a second amplifier each having an input, said inputs being driven from a signal source with a same signal in a phase relationship other than zero, said first and second amplifiers each further having an output; and
a three terminal output network having a first input node coupled to said output of said first amplifier, a second input coupled to said output of said second amplifier, and an output node for coupling to a load, said output network operating in a first, balanced mode of operation for combining the output signals in-phase from both of said first and second amplifiers and for outputting a signal to said output node, said output network operating in a second, unbalanced mode of operation for introducing a predetermined amount of loss into the output signal from only one of said amplifiers for outputting the signal to said output node.

2. An RF power amplifier circuit as in claim 1, wherein said phase relationship is 180 degrees.

3. An RF power amplifier circuit as in claim 1, wherein said phase relationship is 90 degrees.

4. An RF power amplifier circuit as in claim 1, and further comprising a switch coupled in series between said input of said first amplifier and the signal source for disconnecting said input from the signal source when operating in the unbalanced configuration.

5. An RF power amplifier circuit as in claim 1, wherein said output network comprises a Wilkinson coupler comprised of a half wavelength stripline Z1 for shifting the outputs of the first and second amplifiers in-phase, two quarter wavelength striplines Z2 and Z3, and a resistor R, wherein a first node of Z1 is coupled to the output of the first amplifier, a second node of Z1 is coupled to a first node of Z2 and a first node of R, a second node of Z2 is coupled to a first node of Z3 and to said output node of said output network, and a second node of Z3 is coupled to the output of the second amplifier and to a second node of R.

6. An RF power amplifier circuit as in claim 5, wherein the impedance of Z1 is about 50 Ω, the impedance of each of Z2 and Z3 is about 70.7 Ω, and wherein R is about 100 Ω, wherein during balanced operation both the first and second amplifiers see a 50 Ω load, and R does not dissipate power, and wherein during the unbalanced mode of operation R dissipates an amount of power that is about equal to the reduction in power achieved by operating only one of the two amplifiers.

7. An RF power amplifier circuit as in claim 1, wherein said output network comprises a power combiner embodied as a circular shaped stripline having four ports P1, P2, P3 and P4 sequentially connected at quarter wavelength or a multiple of quarter wavelength spacing, wherein P1 and P3 are input ports coupled to the outputs of the first and second amplifiers, wherein P2 is coupled to ground through a resistance R, and wherein P4 is an output port coupled to said output port of said output network.

8. An RF power amplifier circuit as in claim 7, wherein the impedance of said circular shaped stripline is about 70.7 Ω.

9. An RF power amplifier circuit as in claim 1, and further comprising circuitry for placing an unused one of said amplifiers, when in the unbalanced mode, in a reduced power consumption state.

10. An RF power amplifier circuit as in claim 1, wherein said circuit is a part of a wireless terminal, and wherein operation in said balanced mode of operation is performed when transmitting data signals, and operation in said unbalanced mode of operation is accomplished when transmitting voice signals.

11. An RF power amplifier circuit as in claim 1, wherein said circuit is a part of a wideband CDMA wireless terminal.

12. An RF power amplifier circuit, comprising:
a first amplifier and a second amplifier each having an input, said inputs being driven from a signal source with a same signal in a phase relationship other than zero, said first and second amplifiers each further having an output; and
a three terminal output network having a first input node coupled to said output of said first amplifier, a second input coupled to said output of said second amplifier, and an output node for coupling to a load, said output network operating in a first, balanced mode of operation for combining the output signals in-phase from both of said first and second amplifiers and for outputting a signal to said output node, said output network operating in a second, unbalanced mode of operation for switchably changing an effective gain of one of said amplifiers by changing the amplifier's load impedance.

13. An RF power amplifier circuit as in claim 12, wherein said output network comprises a half wavelength stripline Z1 for shifting the outputs of the first and second amplifiers in-phase, two quarter wavelength striplines Z2 and Z3, and a switch S, wherein a first node of Z1 is coupled to the output of the first amplifier, a second node of Z1 is coupled to a first node of Z2 and to a first node of the switch S, a second node of Z2 is coupled to a first node of Z3 and to said output node of said output network, a second node of Z3 is coupled to the output of the second amplifier, and a second node of the switch S is coupled to ground, wherein the switch S is opened when operating in the balanced mode of operation and is closed when operating in the unbalanced mode of operation, whereby the impedance of Z2 is transformed to appear as substantially as an open circuit to the signal output from the second amplifier.

14. An RF power amplifier circuit as in claim 13, wherein the impedance of each of Z1, Z2 and Z3 is about 70.7 Ω, and wherein for a constant load impedance of 50 Ω Z3 effectively transforms the impedance seen by the output of the second amplifier to about 100 Ω.

15. An RF power amplifier circuit as in claim 12, wherein said phase relationship is 180 degrees.

16. An RF power amplifier circuit as in claim 12, wherein said phase relationship is 90 degrees.

17. An RF power amplifier circuit as in claim 12, and further comprising a switch coupled in series between said input of said first amplifier and the signal source for disconnecting said input from the signal source when operating in the unbalanced configuration.

18. An RF power amplifier circuit as in claim 12, and further comprising circuitry for placing an unused one of said amplifiers, when in the unbalanced mode, in a reduced power consumption state.

19. An RF power amplifier circuit as in claim 12, wherein said circuit is a part of a wireless terminal, and wherein operation in said balanced mode of operation is performed when transmitting data signals, and operation in said unbalanced mode of operation is accomplished when transmitting voice signals.

20. An RF power amplifier circuit as in claim 12, wherein said circuit is a part of a wideband CDMA wireless terminal.
